Europäisches Patentamt

European Patent Office

Office européen des brevets

(11)     EP 1 156 586 B1

(19)

(12)     **FASCICULE DE BREVET EUROPEEN**

(45) Date de publication et mention
de la délivrance du brevet:
**07.09.2005   Bulletin 2005/36**

(51) Int Cl.[7]: **H03M 1/14**, H03M 3/02

(21) Numéro de dépôt: **01401228.0**

(22) Date de dépôt: **14.05.2001**

(54) **Convertisseur analogique-numérique pipeline avec mise en forme de bruit**

Analog-Digital-Wandler nach dem Fliessbandverfahren mit Rauschformung

Pipelined analogue-to-digital converter with noise-shaping

(84) Etats contractants désignés:
**DE FR GB**

(30) Priorité:  **16.05.2000  FR 0006198**

(43) Date de publication de la demande:
**21.11.2001   Bulletin 2001/47**

(73) Titulaire: **STMicroelectronics S.A.
92120 Montrouge (FR)**

(72) Inventeurs:
• **André, Eric
38180 Seyssins (FR)**
• **Paillardet, Frédéric
73100 Aix-les-Bains (FR)**

(74) Mandataire: **Texier, Christian et al
Cabinet Régimbeau
20, rue de Chazelles
75847 Paris cedex 17 (FR)**

(56) Documents cités:
**WO-A-00/08765**

• **BROOKS T L ET AL: "A CASCADED
SIGMA-DELTA PIPELINE A/D CONVERTER
WITH 1.25 MHZ SIGNAL BANDWIDTH AND 89 DB
SNR" IEEE JOURNAL OF SOLID-STATE
CIRCUITS,IEEE INC. NEW YORK,US, vol. 32, no.
12, 1 décembre 1997 (1997-12-01), pages
1896-1906, XP000767440 ISSN: 0018-9200**

**Description**

L'invention concerne les convertisseurs analogique-numérique.

Les convertisseurs analogique-numérique se classent en deux grandes familles : les CAN large bande (quelques MHz) avec une résolution moyenne (jusqu'à 10 bits effectifs), et les CAN bande étroite (quelques kHz) et une résolution élevée (jusqu'à 16 bits et plus).

La conversion analogique-numérique pipeline et la modulation $\Delta\Sigma$ font parties des nombreuses techniques connues dans le domaine de la conversion analogique-numérique. Les CAN pipeline ont généralement une large bande passante (quelques MHz) et une résolution moyenne : de l'ordre de 8 à 10 bits effectifs. Au contraire, les modulateurs $\Delta\Sigma$ sont utilisés pour convertir des signaux avec une résolution élevée (jusqu'à 16 bits et plus), mais sur une bande de fréquences généralement étroite (quelques kHz).

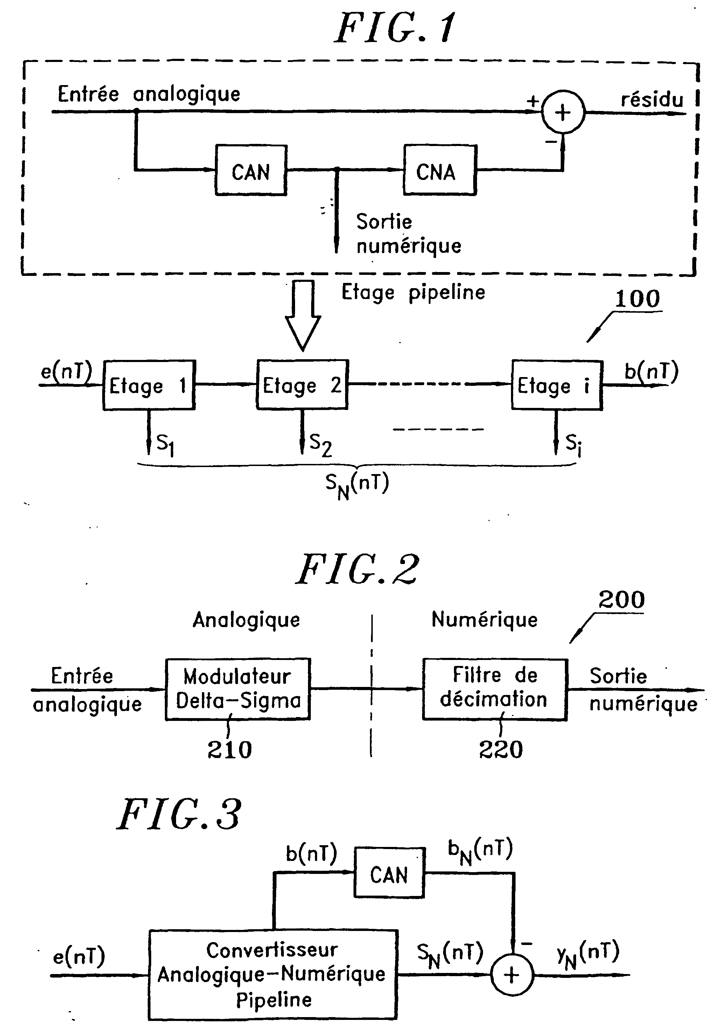

Le convertisseur pipeline se compose d'étages de conversion analogique-numérique élémentaires qui sont disposés en pipeline. Chaque étage du pipeline fournit un nombre de bits qui contribue au codage numérique du signal. Le principe de fonctionnement de l'étage pipeline consiste à numériser le signal d'entrée sur un faible nombre de bits au moyen d'un convertisseur de type flash. Ensuite, ce code numérique est reconstruit en un signal analogique avant de le soustraire au signal d'entrée (voir Figure 1). Le signal résultant est appelé le résidu. Chaque étage pipeline traite le résidu de l'étage précédent (sauf le premier étage qui reçoit le signal d'entrée) et délivre un nouveau résidu à l'étage suivant.

De par la précision des composants, le nombre d'étages et la résolution d'un convertisseur analogique-numérique pipeline sont limités. Par contre, cette technique présente l'avantage d'avoir une bande de conversion pouvant atteindre plusieurs MHz.

Le convertisseur analogique-numérique delta-sigma se compose d'un modulateur delta-sigma suivi d'un décimateur. Le modulateur delta-sigma suréchantillone le signal d'entrée et rejette le bruit de quantification en dehors de la bande utile. Le décimateur filtre dans le domaine numérique le bruit de quantification mis en forme et ramène le débit du signal de sortie à la fréquence de Nyquist.

Grâce au suréchantillonage et la mise en forme du bruit de quantification, la modulation delta-sigma permet d'atteindre des performances élevées. Toutefois, la bande de conversion est généralement limitée à quelques kilohertz.

Le document WO 00/08765 divulgue un modulateur delta-sigma approprié pour les convertisseurs analogiques/numériques à grande largeur de bande et à haute résolution.

Le but de la présente invention est de proposer un convertisseur analogique/numérique qui ait une résolution importante sur une bande de fréquence choisie tout en laissant une performance acceptable en dehors de cette bande choisie.

Ce but est atteint selon l'invention grâce à un convertisseur analogique/numérique incluant un premier module du type ayant une série d'étages de traitement, ces étages de traitement réalisant chacun deux conversions d'abord analogique/numérique puis numérique/analogique du signal de sortie de l'étage précédent, puis une soustraction du signal ainsi obtenu au signal de sortie de l'étage précédent pour fournir ainsi le signal de sortie analogique dudit étage, ledit premier module comportant en outre des moyens pour assembler les signaux numérisés par chaque étage afin de former un signal numérique qui représente sous une forme numérique le signal d'entrée du convertisseur, caractérisé en ce que le convertisseur inclut en outre un modulateur qui numérise le signal de sortie d'un desdits étages ainsi que des moyens pour soustraire le signal ainsi numérisé audit signal numérique assemblé.

L'invention propose également pour cela un procédé pour réaliser une conversion analogique/numérique d'un signal d'entrée en un signal de sortie dans lequel on réalise, une série d'étapes de traitement dans lesquelles on réalise, dans chacune, deux conversions d'abord analogique/numérique puis numérique/analogique d'un signal-résultat de l'étape précédente puis une soustraction du signal analogique ainsi obtenu au signal-résultat de l'étape précédente pour fournir ainsi le signal-résultat de l'étape considérée, dans lequel procédé on assemble les signaux numérisés à chaque étape afin de former un signal numérique qui représente sous une forme numérique le signal d'entrée, caractérisé en ce que l'on numérise en outre le signal-résultat d'une desdites étapes à l'aide d'un modulateur delta-sigma et on soustrait ce signal numérisé audit signal numérique assemblé.

D'autres buts, avantages et caractéristiques de l'invention apparaîtront à la lecture détaillée de la description qui va suivre, faite en référence aux dessins annexés sur lesquels :

- la figure 1 représente un convertisseur analogique/numérique de type pipeline selon l'art antérieur ;
- la figure 2 représente un convertisseur delta sigma selon l'art antérieur ;
- la figure 3 représente un convertisseur analogique/numérique dans lequel un convertisseur pipeline est associé à un convertisseur analogique/numérique supplémentaire placé à sa sortie ;
- la figure 4 représente un convertisseur analogique/numérique selon l'invention ;
- la figure 5 est un tracé représentant le signal de sortie d'un convertisseur analogique/numérique pipeline selon l'art antérieur ;

- la figure 6 représente est un tracé représentant le signal de sortie d'un convertisseur analogique/numérique pipeline selon l'invention.

Le résidu fourni par le dernier étage d'un convertisseur analogique-numérique pipeline 100 correspond au bruit de quantification du convertisseur pipeline, tel que :

$$b(nT) = s_N(nT) - e(nT) \text{ où } b(nT)$$

est le bruit de quantification du CAN pipeline, $s_N(nT)$ est le signal de sortie numérique et $e(nT)$ est le signal d'entrée analogique du convertisseur.

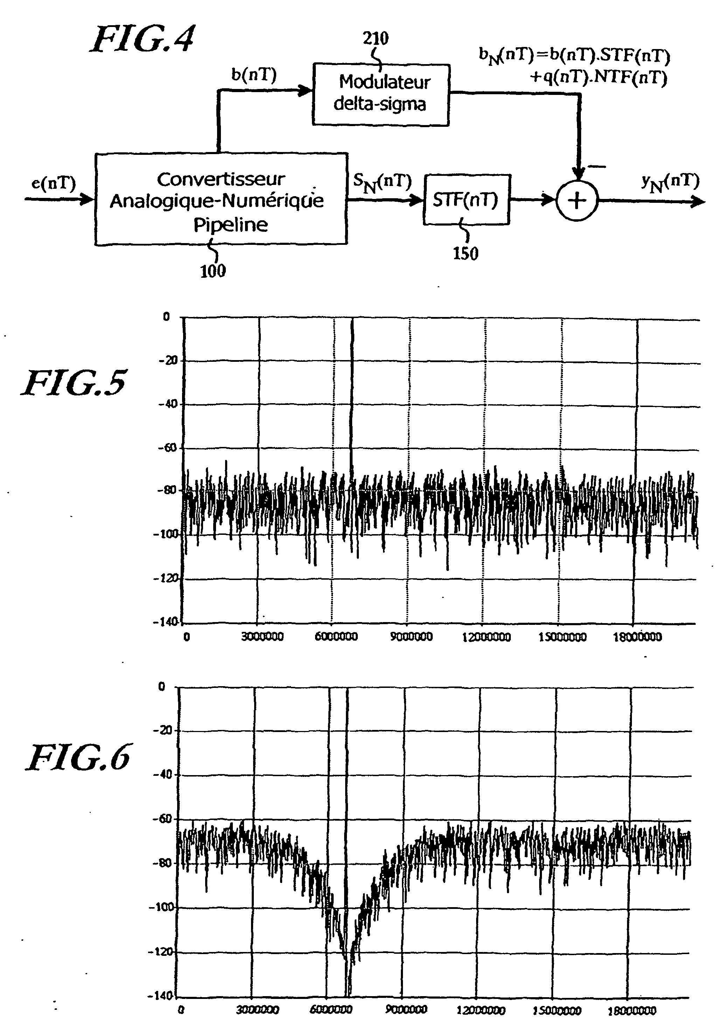

Dans le présent dispositif décrit représenté aux figures 3 et 4, on numérise le signal d'erreur $b(nT)$ afin de pouvoir le soustraire au signal de sortie numérique $s_N(nT)$ de sorte que $s_N(nT) = e(nT)+b(nT)-b_N(nT)$ où $b_N(nT)$ est la représentation de $b(nT)$ dans le domaine numérique. Plus cette représentation sera fidèle, meilleures seront les performances du convertisseur analogique-numérique selon le système proposé. L'idéal étant d'avoir $b_N(nT) = b(nT)$.

Afin d'avoir une grande précision sur $b_N(nT)$, le système proposé utilise un modulateur delta-sigma 210. Ce modulateur 210 augmente les performances du convertisseur analogique-numérique pipeline 100 sur une partie de sa bande de conversion.

Les caractéristiques du modulateur delta-sigma 210 utilisé vont conditionner à la fois le gain en performances, la largeur de la bande de conversion à performance accrue, et la complexité totale du système proposé.

Le signal $b_N(nT)$ délivré par le modulateur delta-sigma 210 se compose du signal numérisé $b(nT)$ multiplié par une fonction de transfert du signal $STF(nT)$ et d'un nouveau bruit de quantification $q(nT)$ multiplié par une fonction de mise en forme $NTF(nT)$ propre au modulateur delta-sigma 210 utilisé.

De manière connue, un modulateur $\Delta\Sigma$ inclut deux fonctions de transfert, une qui est vue par le signal d'entrée du modulateur, l'autre qui est vue par le bruit de quantification (fonction de mise en forme du bruit NTF(nT)).

Un module 150 applique une fonction de transfert qui est la même que la fonction vue par le signal d'entrée du modulateur $\Delta\Sigma$ 210.

Avant de soustraire le signal $b_N(nT)$ à $s_N(nT)$, on multiplie donc à l'aide du module 150 ce dernier par la fonction de transfert $STF(nT)$ propre au modulateur delta-sigma. Ainsi, on obtient le signal $y_N(nT)$ tel que :

$$y_N(nT) = S_N(nT). STF(nT) - [b(nT).STF(nT) + q(nT).NTF(nT)]$$

Il faut en effet que l'autre des deux signaux qui sont soustraits ait également été traité par cette fonction de transfert pour obtenir une efficacité optimale.

Généralement, la fonction de transfert de signal est composée uniquement d'un ou plusieurs retards et on considère $STF(nT) = 1$ (au retard près) afin de simplifier le calcul :

$$y_N(nT) = e(nT) - q(nT).NTF(nT)$$

Ainsi, le nouveau signal numérique obtenu avec le système proposé se compose de l'image du signal d'entrée sur lequel se superpose un bruit de quantification de puissance qui est plus faible dans une bande de fréquences données.

Les performances du CAN sont alors augmentées, mais sur une bande de conversion réduite par l'utilisation de la modulation delta-sigma (mise en forme du bruit de quantification). Un filtre numérique de décimation 220 est alors nécessaire pour supprimer le bruit de quantification rejeté en dehors de la bande de conversion.

Le système proposé a été modélisé et simulé sur un outil de traitement du signal. Pour valider l'idée originale, un convertisseur analogique-numérique pipeline 100 de 8 bits et un modulateur delta-sigma 210 passe-bande 1 bit d'ordre 4 ont été choisis. La fréquence de travail est de 40 MHz. Le système proposé est testé en appliquant un signal sinusoïdal de fréquence 6.7 MHz.

La Figure 5 montre le signal de sortie du CAN pipeline 100 à 8 bits (fonctionnement classique) sur une bande de conversion de 20 MHz. Les performances du CAN 100 en terme de rapport signal à bruit (SNR) sont de 50 dB (8 bits) sur une bande de 20 MHz et de 70 dB (presque 12 bits effectifs) sur une bande de 200 kHz autour du signal (6,58 - 6,78 MHz).

La Figure 6 montre le signal de sortie du système proposé (fonctionnement optimisé) sur une bande de 20 MHz. Sur une bande de 200 kHz autour du signal (6,58 - 6,78 MHz), le rapport signal à bruit est de 109 dB (environ 18 bits effectifs).

Le système proposé permet donc d'augmenter les performances d'un convertisseur analogique-numérique pipeline sur une bande de fréquences donnée grâce à l'utilisation d'un modulateur delta-sigma (et d'une fonction numérique de traitement du signal). Ce dernier numérise le résidu du dernier étage pipeline avec une grande précision afin de réduire la puissance du bruit de quantification dans une bande de fréquence donnée.

On a donc décrit ici également un procédé de conversion analogique-numérique (CAN) de type pipeline sur lequel le bruit de quantification résiduel est traité par un modulateur $\Delta\Sigma$ afin d'optimiser ses performances sur une bande de fréquences données.

Grâce au dispositif décrit ici, on a en outre la possibilité d'adapter les performances du convertisseur analogique-numérique sur une bande de conversion utile que l'on choisit.

Si une large bande de conversion est nécessaire, des moyens non représentés sur les figures sont prévus pour désactiver le modulateur delta-sigma 210 (de tels moyens sont par exemple un simple interrupteur), le CAN fonctionnant alors classiquement dans son mode pipeline.

Si des performances plus élevées sont nécessaires sur une largeur de bande réduite, on active le modulateur delta-sigma 210. Le système proposé permet plus généralement d'optimiser les performances du CAN autour d'une bande utile choisie, en connectant sur le CAN pipeline un modulateur delta-sigma adapté, par exemple en connectant à l'aide de moyens de connexion classiques, un modulateur delta-sigma passe-bas ou passe-bande selon le besoin.

Une telle possibilité de choix du modulateur delta sigma existe donc non seulement au stade de fabrication du dispositif mais également en utilisation dans le cas d'un tel dispositif muni de plusieurs modulateurs et de moyens de commutation pour choisir celui de ces modulateurs qui est associé au CAN pipeline.

Un tel système est particulièrement adapté aux terminaux de communication multi-modes où les composants utilisés dans la chaîne de réception doivent se reconfigurer en fonction de l'application choisie afin de partager les ressources matérielles. De tels terminaux sont en particulier utilisés dans les télécommunications par ondes hertziennes, notamment dans le domaine du téléphone.

## Revendications

1.  Convertisseur analogique/numérique incluant un premier module (100) du type ayant une série d'étages de traitement, ces étages de traitement réalisant chacun deux conversions d'abord analogique/numérique puis numérique/analogique du signal de sortie de l'étage précédent, puis une soustraction du signal ainsi obtenu au signal de sortie de l'étage précédent pour fournir ainsi le signal de sortie analogique dudit étage, ledit premier module (100) comportant en outre des moyens pour assembler les signaux numérisés par chaque étage ($S_1$..., $S_i$) afin de former un signal numérique ($s_N(nT)$) qui représente sous une forme numérique le signal d'entrée ($e(nT)$) du convertisseur, **caractérisé en ce que** le convertisseur inclut en outre un modulateur delta-sigma (210) qui numérise le signal de sortie ($b(nT)$) d'un desdits étages ainsi que des moyens pour soustraire le signal ainsi numérisé audit signal numérique assemblé ($s_N(nT)$).

2.  Convertisseur selon la revendication 1, **caractérisé en ce que** les moyens pour soustraire ledit signal ainsi numérisé audit signal numérique assemblé ($S_N(nT)$), incluent des moyens (150) mettant en oeuvre sur le signal assemblé un traitement correspondant à la fonction de transfert ($STF(nT)$) du modulateur $\Delta\Sigma$ (210) qui est appliquée au signal d'entrée de ce modulateur $\Delta\Sigma$.

3.  Convertisseur selon la revendication 1 ou la revendication 2, **caractérisé en ce que** le modulateur delta-sigma (200) est placé en sortie du dernier étage du premier module (100).

4.  Convertisseur selon l'une quelconque des revendications précédentes, **caractérisé en ce qu'**il comporte des moyens pour désactiver le modulateur delta-sigma (210).

5.  Convertisseur selon l'une quelconque des revendications précédentes, **caractérisé en ce qu'**il comporte plusieurs modulateurs delta-sigma (210) aptes chacun à numériser le signal de sortie d'un desdits étages, et des moyens de commutation pour activer un modulateur delta-sigma choisi parmi ces modulateurs delta-sigma (210).

6.  Convertisseur selon l'une quelconque des revendications précédentes, **caractérisé en ce qu'**il inclut un filtre de décimation (220) placé en aval desdits moyens pour assembler les signaux numérisés par chaque étage.

7.  Terminal de communications comportant des moyens de choix d'une bande de fréquences d'émission ou de réception de signaux, **caractérisé en ce qu'**il inclut un convertisseur selon l'une quelconque des revendications précédentes.

**8.** Procédé pour réaliser une conversion analogique/numérique d'un signal d'entrée ($e(n_T)$) en un signal de sortie ($y_N(nT)$) dans lequel on réalise une série d'étapes de traitement dans lesquelles on réalise, dans chacune, deux conversions d'abord analogique/numérique puis numérique/analogique d'un signal-résultat de l'étape précédente puis une soustraction du signal analogique ainsi obtenu au signal-résultat de l'étape précédente pour fournir ainsi le signal-résultat de l'étape considérée, dans lequel procédé on assemble les signaux numérisés à chaque étape ($S_1...,\ S_i$) afin de former un signal numérique ($s_N(nT)$) qui représente sous une forme numérique le signal d'entrée ($e(nT)$), **caractérisé en ce que** l'on numérise en outre le signal-résultat d'une desdites étapes ($b(nT)$) à l'aide d'un modulateur delta-sigma (210) et on soustrait ce signal numérisé ($b_N(nT)$) audit signal numérique assemblé ($s_N(nT)$).

**9.** Procédé selon la revendication 8, **caractérisé en ce que** l'on met en oeuvre (150) sur le signal assemblé ($S_N(nT)$) un traitement correspondant à la fonction de transfert (STF(nT)) du modulateur delta-sigma (210) qui est appliquée au signal d'entrée de ce modulateur $\Delta\Sigma$ (210).

**Patentansprüche**

**1.** Analog/Digital-Wandler, der ein erstes Modul (100) der Bauart umfaßt, die eine Reihe von Verarbeitungsstufen aufweist, wobei jede dieser Verarbeitungsstufen folgendes durchführt: zwei Umwandlungen, zuerst analog/digital, dann digital/analog des Ausgangssignals der vorhergehenden Stufe, anschließend eine Subtraktion des so erhaltenen Signals vom Ausgangssignal der vorhergehenden Stufe, um damit das analoge Ausgangssignal der Stufe bereitzustellen, wobei das erste Modul (100) außerdem Mittel zum Zusammensetzen der von allen Stufen ($S_1$ ..., $S_i$) digitalisierten Signale umfaßt, um ein digitales Signal ($s_N(nT)$) zu bilden, das in digitaler Form das Eingangssignal ($e(nT)$) des Wandlers repräsentiert, **dadurch gekennzeichnet, daß** der Wandler außerdem einen Delta-Sigma-Modulator (210), der das Ausgangssignal ($b(nT)$) einer der Stufen digitalisiert, sowie Mittel zur Subtraktion des so digitalisierten Signals vom zusammengesetzten digitalen Signal ($s_N(nT)$) umfaßt.

**2.** Wandler nach Anspruch 1, **dadurch gekennzeichnet, daß** die Mittel zum Subtrahieren des so digitalisierten Signals vom zusammengesetzten digitalen Signal ($S_N(nT)$) Mittel (150) umfassen, die auf das zusammengesetzte Signal eine Verarbeitung anwenden, die der Übertragungsfunktion (STF(nT)) des $\Delta\Sigma$-Modulators (210), die auf das Eingangssignal dieses $\Delta\Sigma$-Modulators angewendet wird, entspricht.

**3.** Wandler nach Anspruch 1 oder Anspruch 2, **dadurch gekennzeichnet, daß** der Delta-Sigma-Modulator (200) am Ausgang der letzten Stufe des ersten Moduls (100) angeordnet ist.

**4.** Wandler nach einem der vorhergehenden Ansprüche, **dadurch gekennzeichnet, daß** er Mittel zum Abschalten des Delta-Sigma-Modulators (210) umfaßt.

**5.** Wandler nach einem der vorhergehenden Ansprüche, **dadurch gekennzeichnet, daß** er folgendes umfaßt: mehrere Delta-Sigma-Modulatoren (210), von denen jeder dafür geeignet ist, das Ausgangssignal einer der Stufen zu digitalisieren, und Schaltmittel zum Einschalten eines Delta-Sigma-Modulators, der unter diesen Delta-Sigma-Modulatoren (210) ausgewählt ist.

**6.** Wandler nach einem der vorhergehenden Ansprüche, **dadurch gekennzeichnet, daß** er einen Dezimationsfilter (220) umfaßt, der nach den Mitteln zum Zusammensetzen der von jeder Stufe digitalisierten Signale angeordnet ist.

**7.** Kommunikationseinrichtung, die Mittel zur Auswahl eines Frequenzbands zum Senden oder Empfangen von Signalen umfaßt, **dadurch gekennzeichnet, daß** sie einen Wandler nach einem der vorhergehenden Ansprüche umfaßt.

**8.** Verfahren zur Durchführung einer Analog/Digital-Wandlung eines Eingangssignals ($e(nT)$) in ein Ausgangssignal ($y_N(nT)$), in dem eine Folge von Verarbeitungsschritten ausgeführt wird, wobei in jedem folgendes ausgeführt wird: zwei Umwandlungen, zuerst analog/digital, dann digital/analog eines Ausgangssignals des vorhergehenden Schrittes, anschließend eine Subtraktion des so erhaltenen analogen Signals vom Ausgangssignal des vorhergehenden Schrittes, um damit das Signalergebnis des betrachteten Schrittes bereitzustellen, wobei in diesem Verfahren die in allen Schritten ($S_1$ ..., $S_i$) digitalisierten Signale zusammengesetzt werden, um ein digitales Signal ($s_N(nT)$) zu bilden, das in digitaler Form das Eingangssignal ($e(nT)$) repräsentiert, **dadurch gekennzeichnet, daß** außerdem das Signalergebnis eines der Schritte ($b(nT)$) mittels eines Delta-Sigma-Modulators (210) digitalisiert und dieses digitalisierte Signal ($b_N$(nT)) vom zusammengesetzten digitalen Signal ($s_N$(nT)) subtrahiert wird.

9.  Verfahren nach Anspruch 8, **dadurch gekennzeichnet, daß** auf das zusammengesetzte Signal ($S_N$(nT)) eine Verarbeitung angewendet wird (150), die der Übertragungsfunktion (STF(nT)) des Delta-Sigma-Modulators (210), die auf das Eingangssignal dieses $\Delta\Sigma$-Modulators (210) angewendet wird, entspricht.

**Claims**

1.  Analogue/digital converter including a first module (100) of the type having a series of processing stages, these processing stages each carrying out two conversions, firstly analogue/digital followed by digital/analogue, of the output signal of the previous stage, followed by a subtraction of the signal thus obtained from the output signal of the previous stage so as to thus provide the analogue output signal of the said stage, the said first module (100) furthermore comprising means for assembling the signals digitized by each stage ($S_1$ ..., $S_i$) so as to form a digital signal ($S_N$(nT)) which represents in a digital form the input signal (e(nT)) of the converter, **characterized in that** the converter furthermore includes a delta-sigma modulator (210) which digitizes the output signal (b(nT)) of one of the said stages as well as means for subtracting the signal thus digitized from the said assembled digital signal ($S_N$(nT)).

2.  Converter according to Claim 1, **characterized in that** the means for subtracting the said signal thus digitized from the said assembled digital signal ($S_N$(nT)) include means (150) implementing on the assembled signal a processing corresponding to the transfer function (STF(nT)) of the $\Delta\Sigma$ modulator (210), which function is applied to the input signal of this $\Delta\Sigma$ modulator.

3.  Converter according to Claim 1 or Claim 2, **characterized in that** the delta-sigma modulator (200) is placed at the output of the last stage of the first module (100).

4.  Converter according to any one of the preceding claims, **characterized in that** it comprises means for deactivating the delta-sigma modulator (210).

5.  Converter according to any one of the preceding claims, **characterized in that** it comprises several delta-sigma modulators (210) each able to digitize the output signal from one of the said stages, and switching means for activating a delta-sigma modulator chosen from among these delta-sigma modulators (210).

6.  Converter according to any one of the preceding claims, **characterized in that** it includes a decimation filter (220) placed downstream of the said means for assembling the signals digitized by each stage.

7.  Communications terminal comprising means for choosing a signals emission or reception frequency band, **characterized in that** it includes a converter according to any one of the preceding claims.

8.  Method for carrying out an analogue/digital conversion of an input signal ($e(n_T)$) into an output signal ($y_N$(nT)) in which a series of processing steps is carried out in which, in each step, two conversions, firstly analogue/digital and then digital/analogue, of a result signal from the previous step are carried out followed by a subtraction of the analogue signal thus obtained from the result signal of the previous step so as to thus provide the result signal of the step considered, in which method the signals digitized at each step ($S_1$ ..., $S_i$) are assembled so as to form a digital signal ($S_N$(nT)) which represents in a digital form the input signal (e(nT)), **characterized in that** the result signal of one of the said steps (b(nT)) is furthermore digitized with the aid of a delta-sigma modulator (210) and this digitized signal ($b_N$(nT)) is subtracted from the said assembled digital signal ($S_N$(nT)).

9.  Method according to Claim 8, **characterized in that** a processing corresponding to the transfer function ($S_{TF}$(nT)) of the delta-sigma modulator (210) is implemented (150) on the assembled signal ($S_N$(nT)), which function is applied to the input signal of this $\Delta\Sigma$ modulator (210).

## FIG.1

Entrée analogique

+

résidu

CAN

CNA

−

Sortie
numérique

Etage pipeline

100

$e(nT)$  →  Etage 1 — Etage 2 — — — — Etage i  →  $b(nT)$

↓ $S_1$   ↓ $S_2$   — — — —   ↓ $S_i$

$S_N(nT)$

## FIG.2

Analogique

Numérique

200

Entrée
analogique  →  Modulateur
Delta−Sigma  →  Filtre de
décimation  →  Sortie
numérique

210

220

## FIG.3

$b(nT)$   CAN   $b_N(nT)$

$e(nT)$  →  Convertisseur
Analogique−Numérique
Pipeline  $S_N(nT)$  −  ⊕  $y_N(nT)$

## FIG.4

## FIG.5

## FIG.6